# EUROPÄISCHE PATENTSCHRIFT

(11) **EP 2 764 594 B1**
(45) Veröffentlichungstag und Bekanntmachung des Hinweises auf die Patenterteilung: **04.05.2016**
(21) Anmeldenummer: 12748421.0
(22) Anmeldetag: 10.08.2012
(51) Int. Cl.: H02M 1/08, H02M 7/5387, H02P 6/14, H03K 17/082, H02M 1/00, H02M 1/36, H02M 1/32

(54) **VORRICHTUNG UND VERFAHREN ZUM ENTLADEN EINES KONDENSATORS EINES WECHSELRICHTERS**
METHOD AND DEVICE FOR DISCHARGING AN INVERTER CAPACITOR
DISPOSITIF ET PROCÉDÉ POUR DÉCHARGER UN CONDENSATEUR D'UN ONDULEUR

(30) Priorität: 04.10.2011 DE 102011083945
(43) Veröffentlichungstag der Anmeldung: 13.08.2014
(73) Patentinhaber: Robert Bosch GmbH, 70442 Stuttgart (DE)
(72) Erfinder: SCHOENKNECHT, Andreas, 71272 Renningen (DE)
(86) Internationale Anmeldenummer: PCT/EP2012/065694
(87) Internationale Veröffentlichungsnummer: WO 2013/050196

(56) Entgegenhaltungen:
- WO-A1-2011/104848
- DE-A1- 4 235 138
- JP-A- 2009 017 750
- US-A1- 2011 080 149
- US-A1- 2011 133 546

## Beschreibung

Die Erfindung betrifft eine Steuervorrichtung für Halbleiterschalter eines Wechselrichters und ein Verfahren zum Ansteuern eines Wechselrichters, insbesondere zum Betreiben eines Wechselrichters in einem Notentladebetrieb.

### Stand der Technik

Elektro- und Hybridfahrzeuge weisen häufig leistungselektronische Schaltungskomponenten im Antriebssystem zwischen Traktionsbatterie und der elektrischen Maschine auf, welche in der Regel als Spannungszwischenkreisumrichter aufgebaut sind. Dabei dient ein Gleichspannungszwischenkreis als Koppelglied zwischen Traktionsbatterie und einem Wechselrichter, welcher zur Übertragung von elektrischer Leistung aus dem Gleichspannungszwischenkreis auf die elektrische Maschine angesteuert werden kann.

Wechselrichter können beispielsweise als Vollbrückenschaltung mit einer Anzahl von Brückenzweigen mit je zwei Halbleiterschaltern ausgeführt sein. Dabei können die mit einem ersten Ausgangsanschluss des Gleichspannungszwischenkreises verbundenen Halbleiterschalter der Brückenzweige jeweils High-Side-Schalter und die mit dem zweiten Ausgangsanschluss des Gleichspannungszwischenkreises verbundenen Halbleiterschalter der Brückenzweige jeweils Low-Side-Schalter bezeichnet werden. Als Halbleiterschalter können dabei beispielsweise IGBT-Module (Bipolartransistoren mit isolierter Gate-Elektrode) mit antiparallel geschalteter Diode oder MOSFETs (Metalloxidfeldeffekttransistoren) verwendet werden.

Zur Ansteuerung des Wechselrichters werden Steuerregelungen verwendet, welche Schaltsignale für die Halbleiterschalter erzeugen. Im Fehlerfall werden aus Sicherheitsgründen verschiedene Anforderungen an die Steuerregelungen gestellt. Beispielsweise kann es erforderlich sein, die Motorwicklungen der elektrischen Maschine im Fehlerfall sicher kurz zu schließen. Dies kann durch ein Schließen aller High-Side-Schalter und Öffnen aller Low-Side-Schalter (oder umgekehrt) bewerkstelligt werden, was auch als "Aktiver Kurzschluss" bezeichnet wird.

Darüber hinaus ist es im Fehlerfall notwendig, den Gleichspannungszwischenkreis schnell und zuverlässig zu entladen, insbesondere auch bei einem Ausfallen von Versorgungsspannungen in der Steuerregelung. Dies kann durch eine Notentladung bewerkstelligt werden. Eine derartige Notentladung wird normativ innerhalb einer maximalen Notentladezeit von fünf Sekunden gefordert, um die elektrische Betriebssicherheit des Fahrzeugs gewährleisten zu können.

Die Druckschrift US 2005/0231171 A1 offenbart ein elektrisches Antriebssystem mit einem elektrischen Motor, einem Pulswechselrichter und einem Zwischenkreiskondensator. Der Zwischenkreiskondensator kann über einen entsprechenden Schalterbetrieb des Pulswechselrichters kontrolliert entladen werden.

Die Druckschrift US 2011/080149 A1 und US 2011/133546 A1 offenbaren ein Wechselrichter wobei der Kondensator ist durch einen Kurzschluss der Brücke gepulst entladen wird.

Die Druckschrift DE 42 35 138 A1 offenbart einen Wechselrichter wobei der Kondensator durch den Motor entladen wird.

Die Druckschrift WO 2011/104848 A1 offenbart ein Wechselrichter wobei der Kondensator durch einen Widerstand entladen wird.

Die Druckschrift JP 2009 017750 A offenbart ein Wechselrichter wobei der Kondensator durch eine Drossel entladen wird.

### Offenbarung der Erfindung

Die vorliegende Erfindung schafft gemäß einem Aspekt eine Steuervorrichtung zum Ansteuern eines Halbleiterschalters eines Wechselrichters, mit einer Schaltsignalverstärkungseinrichtung, welche dazu ausgelegt ist, ein durch eine Steuerregelung des Wechselrichters erzeugtes Schaltsignal zu verstärken und ein erstes Schaltsteuersignal zu erzeugen, welches den Halbleiterschalter in einem Schaltbetrieb ansteuert, einer Stromregeleinrichtung, welche mit einem Stromsensorausgang des Halbleiterschalters gekoppelt ist, und welche dazu ausgelegt ist, ein zweites Schaltsteuersignal zu erzeugen, welches den Halbleiterschalter in einem Linearbetrieb ansteuert, und einer Auswahleinrichtung, welche mit der Schaltsignalverstärkungseinrichtung und der Stromregeleinrichtung gekoppelt ist, und welche dazu ausgelegt ist, in Abhängigkeit von mindestens einem Betriebswahlsignal entweder das erste Schaltsteuersignal oder das zweite Schaltsteuersignal zum Ansteuern eines Steueranschlusses des Halbleiterschalters auszugeben.

Gemäß einem weiteren Aspekt schafft die vorliegende Erfindung ein Antriebssystem für eine n-phasige elektrische Maschine, wobei n ≥ 1, mit einem Zwischenkreiskondensator, welcher mit zwei Eingangsspannungsanschlüssen verbunden ist, einem Wechselrichter mit einer Vielzahl von Halbleiterschaltern, welcher mit dem Zwischenkreiskondensator gekoppelt ist, aus dem Zwischenkreiskondensator mit elektrischer Energie gespeist wird und dazu ausgelegt ist, eine n-phasige Versorgungsspannung für die elektrische Maschine zu erzeugen, einer Vielzahl von erfindungsgemäßen Steuervorrichtungen, welche jeweils dazu ausgelegt sind, ein Schaltsteuersignal für einen der Halbleiterschalter des Wechselrichters zu erzeugen, und einer Steuerregelung, welche mit der Vielzahl der Steuervorrichtungen gekoppelt ist, und welche dazu ausgelegt ist, Schaltsignale für die Halbleiterschalter des Wechselrichters zu erzeugen.

Gemäß einem weiteren Aspekt schafft die vorliegende Erfindung ein Verfahren zum Ansteuern eines Wechselrichters, mit den Schritten des Verstärkens eines Schaltsignals für jeden der Halbleiterschalter des Wechselrichters zum Erzeugen einer Vielzahl von ersten Schaltsteuersignalen, welche jeweils einen Halbleiterschalter in einem Schaltbetrieb ansteuern, des Messens der Stromstärke eines Stroms durch jeden der Halbleiterschalter, des Erzeugens einer Vielzahl von zweiten Schaltsteuersignalen, welche jeweils einen Halbleiterschalter in einem Linearbetrieb ansteuern, in Abhängigkeit von der gemessenen Stromstärke des Stroms durch die Halbleiterschalter, und des Auswählens des ersten Schaltsteuersignals oder des zweiten Schaltsteuersignals zum Ansteuern eines Steueranschlusses jedes der Halbleiterschalter in Abhängigkeit von mindestens einem Betriebswahlsignal für jeden der Halbleiterschalter.

### Vorteile der Erfindung

Eine Idee der vorliegenden Erfindung ist es, eine Steuervorrichtung für Halbleiterschalter eines Wechselrichters in einem elektrisch betriebenen Fahrzeug auszugestalten, die eine Notentladung umsetzen kann, ohne auf zusätzliche Bauteile angewiesen zu sein. Die Notentladung wird dabei über in dem Wechselrichter ohnehin vorhandenen Halbleiterschalter durchgeführt. Dadurch entfällt die Notwendigkeit, dedizierte Notentladeschaltungen vorzusehen, was eine erhebliche Kosten- und Bauraumersparnis mit sich bringen kann.

Ein Vorteil der Erfindung ist es, dass ein mit einer erfindungsgemäßen Steuervorrichtung ausgestalteter Wechselrichter, welcher eine Vielzahl von Brückenzweigen mit jeweils zwei Halbleiterschaltern umfasst, derart angesteuert werden kann, dass das mindestens eine Betriebswahlsignal einen Notentladebetrieb des Wechselrichters angibt. In dem Notentladebetrieb können Low-Side-Schalter des Wechselrichters, das heißt die Halbleiterschalter auf einer Brückenseite jedes Brückenzweigs, mit dem ersten Schaltsteuersignal angesteuert werden, und High-Side-Schalter des Wechselrichters, das heißt die Halbleiterschalter auf der jeweils anderen Brückenseite jedes Brückenzweigs, mit dem zweiten Schaltsteuersignal angesteuert werden. Dadurch ergibt sich eine Kopplung der Eingangsanschlüsse des Wechselrichters mit entsprechenden Ausgangsanschlüssen des Wechselrichters über die im Linearbetrieb angesteuerten Halbleiterschalter, welche dann als Stromregler betrieben werden. Dies bietet den Vorteil, dass ein an die Eingangsanschlüsse des Wechselrichters angeschlossener Zwischenkreiskondensator schnell und zuverlässig über die Halbleiterschalter im Linearbetrieb entladen werden kann.

Besonders vorteilhaft ist dabei, dass zum Einen keine weiteren Schaltungskomponenten zum Entladen des Zwischenkreiskondensators verbaut werden müssen, was Platz und Fertigungskosten spart. Zum Anderen sind die Halbleiterschalter ohnehin sehr gut thermisch an die Umgebung angebunden, so dass ein Entladen des Zwischenkreiskondensators über den Wechselrichter keine Überhitzung des Antriebssystems verursacht.

Gemäß einer Ausführungsform kann die Steuervorrichtung weiterhin eine Stromüberwachungseinrichtung umfassen, welche mit dem Stromsensorausgang des Halbleierschalters und der Schaltsignalverstärkungseinrichtung gekoppelt ist, und welche dazu ausgelegt ist, die Schaltsignalverstärkungseinrichtung zum Erzeugen eines den Halbleiterschalter abschaltenden ersten Schaltsteuersignals anzusteuern, wenn der Strom durch den Halbleiterschalter einen vorbestimmten Stromschwellwert überschreitet. Die Stromüberwachungseinrichtung bietet vorteilhafterweise einen Schutz gegen Kurzschlüsse bei der Ansteuerung der Halbleiterschalter im Schaltbetrieb.

Gemäß einer weiteren Ausführungsform kann die Steuervorrichtung zum Ansteuern eines IGBT-Schalters ausgelegt ist. Dies bietet den Vorteil, dass die Stromregeleinrichtung mit dem Kollektoranschluss des IGBT-Schalters gekoppelt und aus dem Kollektoranschluss mit Betriebsspannung versorgt werden kann. Dadurch sind keine zusätzlichen Komponenten in der Ansteuerung des Wechselrichters notwendig.

Weitere Merkmale und Vorteile von Ausführungsformen der Erfindung ergeben sich aus der nachfolgenden Beschreibung mit Bezug auf die beigefügten Zeichnungen.

### Kurze Beschreibung der Zeichnungen

Es zeigen:
- Fig. 1: eine schematische Darstellung eines elektrischen Antriebssystems eines Fahrzeugs gemäß einer Ausführungsform der Erfindung;
- Fig. 2: eine schematische Darstellung einer Steuervorrichtung für einen Halbleiterschalter gemäß einer weiteren Ausführungsform der Erfindung; und
- Fig. 3: eine schematische Darstellung eines Verfahrens zum Ansteuern eines Wechselrichters gemäß einer weiteren Ausführungsform der Erfindung.

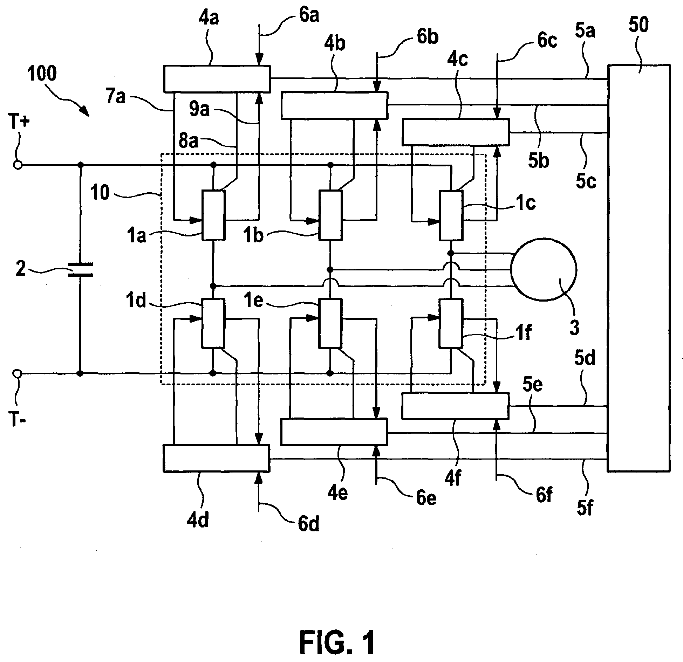

Fig. 1 zeigt eine schematische Darstellung eines elektrischen Antriebssystems 100 eines Fahrzeugs. Das elektrische Antriebssystem 100 umfasst zwei Eingangsanschlüsse T+ und T-, welche beispielsweise durch eine Energiespeichereinrichtung wie eine Hochspannungsbatterie oder eine Traktionsbatterie des Fahrzeugs mit Hochspannung versorgt werden können. Die Eingangsanschlüsse T+ und T- sind mit einem Gleichspannungszwischenkreis verbunden, welcher einen Zwischenkreiskondensator 2 aufweist. Der Zwischenkreiskondensator 2 ist über Ausgangsanschlüsse mit Eingangsanschlüssen eines Wechselrichters 10, beispielsweise eines Pulswechselrichters 10, verbunden. Der in Fig. 1 dargestellte Spannungszwischenkreisumrichter mit dem Zwischenkreiskondensator 2 und dem Wechselrichter 10 ist beispielhaft als dreiphasiger Umrichter dargestellt, das heißt, der Wechselrichter 10 umfasst drei Brückenzweige mit jeweils zwei Halbleiterschaltern. Der erste Brückenzweig umfasst beispielsweise die Halbleiterschalter 1 a und 1 d, der erste Brückenzweig beispielsweise die Halbleiterschalter 1 b und 1e und der dritte Brückenzweig beispielsweise die Halbleiterschalter 1c und 1f. Dabei werden die Halbleiterschalter 1a, 1b, 1c einer Brückenseite als High-Side-Schalter bezeichnet, und die Halbleiterschalter 1 d, 1 e, 1f der anderen Brückenseite als Low-Side-Schalter. Es sollte dabei klar sein, dass jede andere Anzahl von Brückenzweigen bzw. Phasen des Spannungszwischenkreisumrichters ebenso möglich ist, und dass die Bezeichnung der Halbleiterschalter 1a bis 1f als High-Side- und Low-Side-Schalter nur beispielhaft gewählt ist.

Die in Figur 1 dargestellten Halbleiterschalter 1a bis 1f können dabei beispielsweise Feldeffekttransistoren (FETs) aufweisen. In einer möglichen Ausführungsform sind die Halbleiterschalter jeweils IGBTs (Insulated Gate Bipolar Transistors), es ist jedoch ebenso möglich, andere Halbleiterschalter in entsprechender Form vorzusehen, zum Beispiel in Form von JFETs (Junction Field-Effect Transistors) oder MOSFETs (Metal Oxide Semiconductor Field-Effect Transistors). Wenn die Halbleiterschalter 1a bis 1f IGBT-Schalter aufweisen, kann es vorgesehen sein, zu jedem der IGBT-Schalter eine in Fig. 1 aus Gründen der Übersichtlichkeit nicht dargestellte Diode anti-parallel zu schalten.

Das elektrische Antriebssystem 100 weist ferner eine Steuerregelung 50 auf, welche dazu ausgelegt ist, Schaltsignale 5a bis 5f zu erzeugen, welche ein schaltendes Ansteuern der Halbleiterschalter 1a bis 1f codieren. Die Schaltsignale 5a bis 5f können dabei beispielsweise einen logisch niedrigen Pegel aufweisen, wenn die Halbleiterschalter 1 a bis 1f geöffnet sein sollen, und einen logisch hohen Pegel, wenn die Halbleiterschalter 1 a bis 1f geschlossen sein sollen. Die Steuerregelung 50 speist die Schaltsignale 5a bis 5f in entsprechende Steuervorrichtungen 4a bis 4f, welche jeweils für die Ansteuerung eines der Halbleiterschalter 1a bis 1f verantwortlich sind. Im Folgenden wird die Kopplung der Steuervorrichtung 4a mit dem zugeordneten Halbleiterschalter 1a erläutert, wobei jede der übrigen Steuervorrichtungen 4b bis 4f entsprechend gekoppelt sein kann.

Die Steuervorrichtung 4a weist einen Steuerausgang auf, über welchen ein Ansteuersignal 7a an einen Steueranschluss des Halbleiterschalters 1a abgegeben werden kann, um den Betrieb des Haltleiterschalters 1 a zu steuern. Über ein Strommesssignal 9a kann die Steuervorrichtung 4a eine Stromstärke eines Stroms durch den Halbleiterschalter 1 a erfassen. Weiterhin kann die Steuervorrichtung 4a über eine Versorgungsleitung 8a mit von einem Leitungsanschluss des Halbleiterschalters 1 a bereitgestellter Spannung versorgt werden. Wenn der Halbleiterschalters 1a einen IGBT-Schalter aufweist, kann es vorgesehen sein, die Versorgungsleitung 8a mit einem Kollektoranschluss des IGBT-Schalters zu koppeln.

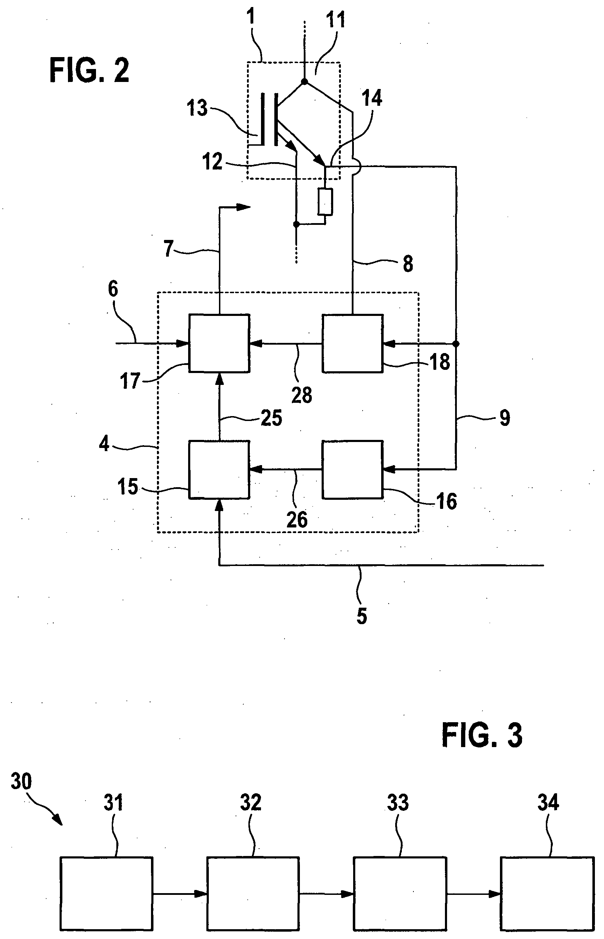

Fig. 2 zeigt eine schematische Darstellung einer Steuervorrichtung 4 für einen Halbleiterschalter 1. Insbesondere ist in Fig. 2 eine beispielhafte Ausführungsform der Steuervorrichtungen 4a bis 4f und der zugehörigen Halbleiterschalter 1a bis 1f in höherem Detail gezeigt. Die in Fig. 2 verwendeten Bezugszeichen können dabei jeweils mit Buchstaben von a bis f versehen werden, um die jeweiligen Komponenten des in Fig. 1 gezeigten elektrischen Antriebssystems 100 zu kennzeichnen.

Die Steuervorrichtung 4 dient zum Ansteuern eines Halbleiterschalters 1, insbesondere eines Halbleiterschalters 1 eines Wechselrichters. Der Halbleiterschalter 1 ist in Fig. 2 beispielhaft als IGBT-Schalter gezeigt, welcher einen Kollektoranschluss 11, einen Emitteranschluss 12, einen Gate- oder Steueranschluss 13 und einen Stromsensorausgang 14 aufweist. Über den Stromsensorausgang 14 kann ein Strommesssignal 9 abgeführt werden, welches die Stromstärke eines momentan durch den IGBT-Schalter 1 fließenden Stroms angibt. Der IGBT-Schalter 1 kann über den Steueranschluss 13 durch Anlegen eines entsprechenden Ansteuersignals 7 mit einem bestimmten Spannungspegel in verschiedenen Betriebsmodi angesteuert werden. In einem Schaltbetrieb kann der IGBT-Schalter 1 nur in einem Sperr- oder Sättigungsbereich betrieben werden, das heißt, der IGBT-Schalter 1 ist entweder vollständig sperrend oder vollständig leitend. In einem Linear- oder Aktivbetrieb hingegen kann der IGBT-Schalter 1 in einem Verstärkungsbereich betrieben werden, das heißt, die Stromstärke eines Stroms durch den IGBT-Schalter 1 skaliert proportional oder im Wesentlichen proportional zu der an dem Steueranschluss anliegenden Spannung.

Die Steuervorrichtung 4 weist eine Schaltsignalverstärkungseinrichtung 15 auf, welche dazu ausgelegt ist, ein Schaltsignal 5 zu verstärken und ein erstes Schaltsteuersignal 25 zu erzeugen. Das Schaltsignal 5 kann beispielsweise durch eine Steuerregelung 50 des Wechselrichters 100 erzeugt werden. Das Schaltsteuersignal 25 dient zur Ansteuerung des Halbleiterschalters 1 in einem Schaltbetrieb.

Die Steuervorrichtung 4 weist weiterhin eine Stromregeleinrichtung 18 auf, welche mit dem Stromsensorausgang 14 des Halbleiterschalters 1 gekoppelt ist, und welche dazu ausgelegt ist, ein zweites Schaltsteuersignal 28 zu erzeugen, welches den Halbleiterschalter 1 in einem Linearbetrieb ansteuert. Dazu kann die Stromregeleinrichtung 18 das zweite Schaltsteuersignal 28 gemäß der Stromstärke des durch den Halbleiterschalter 1 fließenden Stroms regeln. Vorteilhafterweise kann die Stromregeleinrichtung 18 dazu das Strommesssignal 9 nutzen, welches bereits durch die weiter unten erläuterte Stromüberwachungseinrichtung 16 genutzt wird. Die Stromregeleinrichtung 18 kann beispielsweise mit dem Kollektoranschluss 11 des IGBT-Schalters 1 gekoppelt sein und aus dem Kollektoranschluss 11 mit Betriebsspannung versorgt werden. Dies ermöglicht es der Stromregeleinrichtung 18, unabhängig von einer Spannungsversorgung der Steuerregelung 5 auch im Fehlerfall der Steuerregelung 5 ordnungsgemäß zu arbeiten.

Die Steuervorrichtung 4 weist weiterhin eine Auswahleinrichtung 17 auf, welche mit der Schaltsignalverstärkungseinrichtung 15 und der Stromregeleinrichtung 18 gekoppelt ist. Die Auswahleinrichtung 17 dient zur Auswahl des ersten Schaltsteuersignals 25 oder des zweiten Schaltsteuersignals 28 zur Ausgabe eines Ansteuersignals 7 für den Steueranschluss 13 des Halbleiterschalters 1. Die Auswahl kann dabei in Abhängigkeit von mindestens einem Betriebswahlsignal 6 erfolgen. Das oder die Betriebswahlsignale 6 können beispielsweise von verschiedenen Komponenten des elektrischen Antriebssystems 100 erzeugt werden, welche einen Fehlerfall und damit das Aktivieren eines Notbetriebsmodus des Wechselrichters 10 kennzeichnen können. Beispielsweise kann das Betriebswahlsignal 6 ein Steuersignal der Steuerregelung, ein Versorgungsspannungssignal der Hochspannungsbatterie oder sonstige Sensorsignale umfassen.

Die Steuervorrichtung 4 kann eine Stromüberwachungseinrichtung 16 aufweisen, welche mit dem Stromsensorausgang 14 des Halbleiterschalters 1 und der Schaltsignalverstärkungseinrichtung 15 gekoppelt ist. Die Stromüberwachungseinrichtung 16 kann eine Kurzschlussstromüberwachung implementieren, das heißt, die Stromüberwachungseinrichtung 16 kann anhand des Strommesssignals 9 erkennen, ob die Stromstärke des durch den Halbleiterschalter 1 fließenden Stroms einen vorbestimmten Stromschwellwert überschreitet. Wenn ein derartiger Kurzschlussstrom erkannt wird, kann die Stromüberwachungseinrichtung 16 die Schaltsignalverstärkungseinrichtung 15 zum Erzeugen eines den Halbleiterschalter 1 abschaltenden ersten Schaltsteuersignals 25 anzusteuern. Dadurch kann der Halbleiterschalter 1 abgeschaltet werden, bevor eine Beschädigung der Leistungselektronik durch zu hohe Ströme auftreten kann.

Mit der Steuervorrichtung 4 kann ein IGBT-Schalter 1 entweder in einem Linearbetrieb oder einem Schaltbetrieb angesteuert werden. Dies ermöglicht insbesondere das Einstellen eines Notentladebetriebs in einem derart angesteuerten Wechselrichter, wodurch in vorteilhafter Weise ein schnelles Entladen eines den Wechselrichter speisenden Zwischenkreiskondensators erfolgen kann. Dabei ist es besonders vorteilhaft, dass die bereits vorhandenen Komponenten des Wechselrichters zur Entladung genutzt werden können, ohne dass zusätzliche Schaltungen oder Entladeelemente wie schaltbare Widerstände oder dergleichen verbaut werden müssten.

Der Linearbetrieb kann beispielsweise dadurch realisiert werden, dass das Ansteuersignal 7 für den Steueranschluss 13 des Halbleiterschalters 1 einen Spannungswert aufweist, welcher zwischen dem Spannungswert für das Einschalten und dem Spannungswert für das Ausschalten des Halbleiterschalters 1 liegt. Alternativ kann der Linearbetrieb beispielsweise dadurch realisiert werden, dass das Ansteuersignal 7 für den Steueranschluss 13 des Halbleiterschalters 1 für einen vordefinierten kurzen Zeitraum auf einen Spannungswert für das Einschalten angehoben wird, und danach wieder auf den Spannungswert für das Ausschalten des Halbleiterschalters 1 abgesenkt wird. Der Zeitraum kann dabei derart gewählt werden, dass der Halbleiterschalter 1 wieder ausgeschaltet wird, bevor dieser die volle Leitfähigkeit erlangt hat.

Fig. 3 zeigt eine schematische Darstellung eines Verfahrens 30 zum Ansteuern eines Wechselrichters, insbesondere eines Wechselrichters 10 in dem in Fig. 1 dargestellten elektrischen Antriebssystem 100 eines elektrisch betriebenen Fahrzeugs. Das Verfahren 30 umfasst in einem ersten Schritt ein Verstärken eines Schaltsignals für jeden der Halbleiterschalter des Wechselrichters zum Erzeugen einer Vielzahl von ersten Schaltsteuersignalen, welche jeweils einen Halbleiterschalter in einem Schaltbetrieb ansteuern. In einem zweiten Schritt erfolgt ein Messen der Stromstärke eines Stroms durch jeden der Halbleiterschalter. Beispielsweise kann die Stromstärke des Stroms durch einen Halbleiterschalter durch Erfassen eines Ausgangssignals eines Strommessausgangs des Halbleiterschalters ermittelt werden.

In einem dritten Schritt 33 erfolgt ein Erzeugen einer Vielzahl von zweiten Schaltsteuersignalen, welche jeweils einen Halbleiterschalter in einem Linearbetrieb ansteuern, in Abhängigkeit von der gemessenen Stromstärke des Stroms durch die Halbleiterschalter. Der Linearbetrieb des Halbleiterschalters kann ein Betreiben des Halbleiterschalters in einem aktiven Verstärkungsbereich umfassen, das heißt, der Halbleiterschalter kann in einem Stromreglermodus betrieben werden.

In einem vierten Schritt 34 erfolgt ein Auswählen des ersten Schaltsteuersignals oder des zweiten Schaltsteuersignals zum Ansteuern eines Steueranschlusses jedes der Halbleiterschalter in Abhängigkeit von mindestens einem Betriebswahlsignal für jeden der Halbleiterschalter. Die Auswahl kann dabei derart getroffen werden, dass im Zusammenspiel der Ansteuerung aller Halbleiterschalter des Wechselrichters ein bestimmter Betriebsmodus realisiert wird. Beispielsweise kann durch Betreiben aller Halbleiterschalter im Schaltbetrieb, das heißt, durch Auswahl des jeweils ersten Schaltsteuersignals für alle Halbleiterschalter, ein Normalbetriebsmodus des Wechselrichters aktiviert werden. Der Normalbetriebsmodus kann beispielsweise eine herkömmliche Ansteuerung des Wechselrichters umfassen, wenn kein Fehlerfall vorliegt.

Gleichermaßen kann nach Auftreten eines Fehlers, beispielsweise bei einem Ausfall der Spannungsversorgung der Steuerregelung, bei einem Unfall des Fahrzeugs oder bei sonstigen die Betriebssicherheit des elektrischen Antriebssystems gefährdenden Situationen, einer von mehreren Notbetriebszuständen aktiviert werden. In einem Modus des "aktiven Kurzschluss" beispielsweise kann jeder der Halbleiterschalter im Schaltbetrieb betrieben werden, so dass alle Halbleiterschalter einer Brückenseite der Brückenzweige, zum Beispiel die High-Side-Schalter, in einen geschlossenen Zustand und alle Halbleiterschalter der jeweils anderen Brückenseite der Brückenzweige, zum Beispiel die Low-Side-Schalter, in einen offenen Zustand versetzt werden. Es versteht sich, dass die Ansteuerung der High-Side- und Low-Side-Schalter jeweils auch umgekehrt erfolgen kann.

Damit kann die elektrische Maschine sicher und zuverlässig über die geschlossenen Halbleiterschalter kurzgeschlossen werden.

Alternativ ist im Fehlerfall eine schnelle Entladung des Zwischenkreiskondensators über die Halbleiterschalter des Wechselrichters möglich. Hierzu können alle Halbleiterschalter einer Brückenseite der Brückenzweige, zum Beispiel die High-Side-Schalter, in einen offenen Zustand versetzt werden. Die jeweils anderen Halbleiterschalter, beispielsweise die Low-Side-Schalter, können dabei statt in einem Schaltbetrieb in einem Linear- oder Aktivbetrieb angesteuert werden, so dass diese Halbleiterschalter als Stromregler fungieren. Es versteht sich, dass die Ansteuerung der High-Side- und Low-Side-Schalter jeweils auch umgekehrt erfolgen kann.

Dadurch kann der Zwischenkreiskondensator über die Halbleiterschalter im Linearbetrieb entladen werden. Die Halbleiterschalter können dabei thermisch an eine Kühleinrichtung oder die Umgebungsluft des elektrischen Antriebssystems angebunden sein, so dass bei der Entladung entstehende Wärme schnell und sicher abgeführt werden kann.

## Patentansprüche

1. Steuervorrichtung (4) zum Ansteuern eines Halbleiterschalters (1) eines Wechselrichters (10), mit:
einer Schaltsignalverstärkungseinrichtung (15), welche dazu ausgelegt ist, ein durch eine Steuerregelung (50) des Wechselrichters (100) erzeugtes Schaltsignal (5) zu verstärken und ein erstes Schaltsteuersignal (25) zu erzeugen, welches den Halbleiterschalter (1) in einem Schaltbetrieb ansteuert;
einer Stromregeleinrichtung (18), welche mit einem Stromsensorausgang (14) des Halbleiterschalters (1) gekoppelt ist, und welche dazu ausgelegt ist, ein zweites Schaltsteuersignal (28) zu erzeugen, welches den Halbleiterschalter (1) in einem Linearbetrieb ansteuert; und
einer Auswahleinrichtung (17), welche mit der Schaltsignalverstärkungseinrichtung (15) und der Stromregeleinrichtung (18) gekoppelt ist, und welche dazu ausgelegt ist, in Abhängigkeit von mindestens einem Betriebswahlsignal (6) entweder das erste Schaltsteuersignal (25) oder das zweite Schaltsteuersignal (28) zum Ansteuern eines Steueranschlusses (13) des Halbleiterschalters (1) auszugeben.

2. Steuervorrichtung (4) nach Anspruch 1, wobei der Linearbetrieb dadurch realisiert wird, dass der Steueranschluss (13) des Halbleiterschalters (1) mit einem Spannungswert angesteuert wird, welcher zwischen dem Spannungswert für das Einschalten und dem Spannungswert für das Ausschalten des Halbleiterschalters (1) liegt, oder wobei der Linearbetrieb dadurch realisiert wird, dass der Steueranschluss (13) des Halbleiterschalters (1) für einen vordefinierten Zeitraum auf einen Spannungswert für das Einschalten angehoben wird, und danach wieder auf den Spannungswert für das Ausschalten des Halbleiterschalters (1) abgesenkt wird, bevor der Halbletierschalter (1) die volle Leitfähigkeit erlangt hat.

3. Steuervorrichtung (4) nach einem der Ansprüche 1 und 2, weiterhin mit:
einer Stromüberwachungseinrichtung (16), welche mit dem Stromsensorausgang (14) des Halbleiterschalters (1) und der Schaltsignalverstärkungseinrichtung (15) gekoppelt ist, und welche dazu ausgelegt ist, die Schaltsignalverstärkungseinrichtung (15) zum Erzeugen eines den Halbleiterschalter (1) abschaltenden ersten Schaltsteuersignals (25) anzusteuern, wenn der Strom durch den Halbleiterschalter (1) einen vorbestimmten Stromschwellwert überschreitet.

4. Steuervorrichtung (4) nach Anspruch 3, wobei die Stromüberwachungseinrichtung (16) dazu ausgelegt ist, die Schaltsignalverstärkungseinrichtung (15) zum Erzeugen eines den Halbleiterschalter (1) abschaltenden ersten Schaltsteuersignals (25) anzusteuern, wenn der Halbleiterschalter (1) im Linearbetrieb angesteuert wird.

5. Steuervorrichtung (4) nach einem der Ansprüche 1 bis 4, welche zum Ansteuern eines IGBT-Schalters (1) ausgelegt ist.

6. Steuervorrichtung (4) nach Anspruch 5, wobei die Stromregeleinrichtung (18) mit dem Kollektoranschluss (11) des IGBT-Schalters (1) gekoppelt ist und aus dem Kollektoranschluss (11) mit Betriebsspannung versorgt wird.

7. Antriebssystem (100) für eine n-phasige elektrische Maschine (3), wobei n ≥ 1, mit:
einem Zwischenkreiskondensator (2), welcher mit zwei Eingangsspannungsanschlüssen (T+; T-) verbunden ist; einem Wechselrichter (10) mit einer Vielzahl von Halbleiterschaltern (1a, ..., 1f), welcher mit dem Zwischenkreiskondensator (2) gekoppelt ist, aus dem Zwischenkreiskondensator (2) mit elektrischer Energie gespeist wird und dazu ausgelegt ist, eine n-phasige Versorgungsspannung für die elektrische Maschine (3) zu erzeugen;
einer Vielzahl von Steuervorrichtungen (4a, ..., 4f) nach jeweils einem der Ansprüche 1 bis 6, welche jeweils dazu ausgelegt sind, ein Schaltsteuersignal (7a, ..., 7f) für einen der Halbleiterschalter (1a, ..., 1f) des Wechselrichters (10) zu erzeugen; und
einer Steuerregelung (50), welche mit der Vielzahl der Steuervorrichtungen (4a, ..., 4f) gekoppelt ist, und welche dazu ausgelegt ist, Schaltsignale (5a, ..., 5f) für die Halbleiterschalter (1a, ..., 1f) des Wechselrichters (10) zu erzeugen.

8. Antriebssystem (100) nach Anspruch 7, wobei die Halbleiterschalter (1a, ..., 1f) IGBT-Schalter sind.

9. Verfahren (30) zum Ansteuern eines Wechselrichters (100), mit den Schritten:
Verstärken (31) eines Schaltsignals (5a, ..., 5f) für jeden der Halbleiterschalter (1a, ..., 1 f) des Wechselrichters (10) zum Erzeugen einer Vielzahl von ersten Schaltsteuersignalen, welche jeweils einen Halbleiterschalter (1 a, ..., 1f) in einem Schaltbetrieb ansteuern;
Messen (32) der Stromstärke eines Stroms durch jeden der Halbleiterschalter (1a, ..., 1f);
Erzeugen (33) einer Vielzahl von zweiten Schaltsteuersignalen, welche jeweils einen Halbleiterschalter (1 a, ..., 1f) in einem Linearbetrieb ansteuern, in Abhängigkeit von der gemessenen Stromstärke des Stroms durch die Halbleiterschalter (1a, ..., 1f); und
Auswählen (34) des ersten Schaltsteuersignals oder des zweiten Schaltsteuersignals zum Ansteuern eines Steueranschlusses jedes der Halbleiterschalter (1a, ..., 1f) in Abhängigkeit von mindestens einem Betriebswahlsignal (6a, ..., 6f) für jeden der Halbleiterschalter (1a, ..., 1f).

10. Verfahren (30) nach Anspruch 9, wobei der Wechselrichter (10) eine Vielzahl von Brückenzweigen mit jeweils zwei Halbleiterschaltern (1 a, ..., 1f) umfasst, wobei das mindestens eine Betriebswahlsignal einen Notentladebetrieb des Wechselrichters (10) angibt, und wobei für jeweils einen Halbleiterschalter (1 a, 1 b, 1 c) jedes Brückenzweigs das erste Schaltsteuersignal und für jeweils den anderen Halbleiterschalter (1 d, 1 e, 1f) jedes Brückenzweigs das zweite Schaltsteuersignal zum Ansteuern der jeweiligen Steueranschlüsse ausgewählt wird.

## Claims

1. Control device (4) for driving a semiconductor switch (1) of an inverter (10), having:
a switching signal amplification means (15) which is designed to amplify a switching signal (5) generated by a control (50) of the inverter (100) and to generate a first switching control signal (25) which drives the semiconductor switch (1) in a switching mode;
a current regulation means (18) which is coupled with a current sensor output (14) of the semiconductor switch (1) and which is designed to generate a second switching control signal (28) which drives the semiconductor switch (1) in a linear mode; and
a selection means (17) which is coupled with the switching signal amplification means (15) and the current regulation means (18) and which is designed to output either the first switching control signal (25) or the second switching control signal (28) as a function of at least one mode selection signal (6) for driving a control terminal (13) of the semiconductor switch (1).

2. Control device (4) according to Claim 1, wherein the linear mode is achieved by the control terminal (13) of the semiconductor switch (1) being driven with a voltage value which lies between the voltage value for switching on and the voltage value for switching off the semiconductor switch (1), or wherein the linear mode is achieved by the control terminal (13) of the semiconductor switch (1) being raised for a predefined period to a voltage value for switching on, and then being lowered again to the voltage value for switching off the semiconductor switch (1), before the semiconductor switch (1) has reached full conductivity.

3. Control device (4) according to one of Claims 1 and 2, furthermore having:
a current monitoring means (16) which is coupled with the current sensor output (14) of the semiconductor switch (1) and the switching signal amplification means (15) and which is designed to drive the switching signal amplification means (15) for generating a first switching control signal (25) which switches off the semiconductor switch (1) if the current flowing through the semiconductor switch (1) exceeds a predetermined threshold current value.

4. Control device (4) according to Claim 3, wherein the current monitoring means (16) is designed to drive the switching signal amplification means (15) for generating a first switching control signal (25) which switches off the semiconductor switch (1) if the semiconductor switch (1) is driven in linear mode.

5. Control device (4) according to one of Claims 1 to 4, which is designed for driving an IGBT switch (1).

6. Control device (4) according to Claim 5, wherein the current regulation means (18) is coupled with the collector terminal (11) of the IGBT switch (1) and is supplied with operating voltage from the collector terminal (11).

7. Drive system (100) for an n-phase electric machine (3), where n ≥ 1, having: an intermediate-circuit capacitor (2) which is connected to two input voltage terminals (T+; T-);
an inverter (10) having a plurality of semiconductor switches (1a, ..., 1f) which is coupled with the intermediate-circuit capacitor (2), is supplied with electric energy from the intermediate-circuit capacitor (2), and is designed to generate an n-phase supply voltage for the electric machine (3);
a plurality of control devices (4a, ..., 4f) according to one of the respective Claims 1 to 6, each of which is designed to generate a switching control signal (7a, ..., 7f) for one of the semiconductor switches (1a, ..., 1f) of the inverter (10); and a control (50) which is coupled with the plurality of the control devices (4a, ..., 4f) and which is designed to generate switching signals (5a, ..., 5f) for the semiconductor switches (1a, ..., 1f) of the inverter (10).

8. Drive system (100) according to Claim 7, wherein the semiconductor switches (1a, ..., 1f) are IGBT switches.

9. Method (30) for driving an inverter (100), having the steps of: amplification (31) of a switching signal (5a, ..., 5f) for each of the semiconductor switches (1a, ..., 1f) of the inverter (10) for generating a plurality of first switching control signals, each of which drives a semiconductor switch (1a, ..., 1f) in a switching mode; measurement (32) of the current intensity of a current flowing through each of the semiconductor switches (1a, ..., 1f);
generation (33) of a plurality of second switching control signals, each of which drives a semiconductor switch (1a, ..., 1f) in a linear mode as a function of the measured current intensity of the current flowing through the semiconductor switches (1a, ..., 1f); and selection (34) of the first switching control signal or the second switching control signal for driving a control terminal of each of the semiconductor switches (1a, ..., 1f) as a function of at least one mode selection signal (6a, ..., 6f) for each of the semiconductor switches (1a, ..., 1f).

10. Method (30) according to Claim 9, wherein the inverter (10) comprises a plurality of bridge arms, each having two semiconductor switches (1a, ..., 1f), wherein the at least one mode selection signal specifies an emergency discharge mode of the inverter (10), and wherein the first switching control signal is selected for driving the respective control terminals for one respective semiconductor switch (1a, 1b, 1c) of each bridge arm, and the second switching control signal is selected for driving the respective control terminals for the other respective semiconductor switch (1d, 1e, 1f) of each bridge arm.

## Revendications

1. Dispositif de commande (4) destiné à commander un commutateur à semi-conducteur (1) d'un onduleur (10), comprenant :
un dispositif d'amplification de signal de commutation (15) qui est conçu pour amplifier un signal de commutation (5) généré par une régulation de commande (50) de l'onduleur (100) et pour générer un premier signal de commande de commutation (25) qui commande le commutateur à semi-conducteur (1) dans un fonctionnement de commutation ;
un dispositif régulateur de courant (18) qui est couplé à une sortie de capteur de courant (14) du commutateur à semi-conducteur (1) et qui est conçu pour générer un deuxième signal de commande de commutation (28) qui commande le commutateur à semi-conducteur (1) dans un fonctionnement linéaire ; et
un appareil de sélection (17) qui est couplé au dispositif d'amplification de signal de commutation (15) et au dispositif régulateur de courant (18) et qui est conçu pour délivrer, en fonction d'au moins un signal de sélection de fonctionnement (6), soit le premier signal de commande de commutation (25) soit le deuxième signal de commande de commutation (28) afin de commander une borne de commande (13) du commutateur à semi-conducteur (1).

2. Dispositif de commande (4) selon la revendication 1, dans lequel le fonctionnement linéaire est réalisé par le fait que la borne de commande (13) du commutateur à semi-conducteur (1) est commandée avec une valeur de tension qui se situe entre la valeur de tension qui rend passant le commutateur à semi-conducteur (1) et la valeur de tension qui le rend non passant, ou dans lequel le fonctionnement linéaire est réalisé par le fait que la borne de commande (13) du commutateur à semi-conducteur (1) est portée à une valeur de tension qui rend passant le commutateur à semi-conducteur (1) pendant un intervalle de temps prédéfini puis est ramenée à la valeur de tension qui rend non passant le commutateur à semi-conducteur avant que le commutateur à semi-conducteur (1) n'ait atteint l'état de conductivité totale.

3. Dispositif de commande (4) selon l'une quelconque des revendications 1 et 2, comportant en outre :
un dispositif de surveillance de courant (16) qui est couplé à la sortie de capteur de courant (14) du commutateur à semi-conducteur (1) et au dispositif d'amplification de signal de commutation (15) et qui est conçu pour commander le dispositif d'amplification (15) afin de générer un premier signal de commande de commutation (25) qui rend non passant le commutateur à semi-conducteur (1) lorsque le courant passant à travers le commutateur à semi-conducteur (1) dépasse une valeur de seuil de courant prédéterminée.

4. Dispositif (4) selon la revendication 3, dans lequel le dispositif de surveillance de courant (16) est conçu pour commander le dispositif d'amplification de signal de commutation (15) afin de générer un premier signal de commande de commutation (25) qui rend non passant le commutateur à semi-conducteur (1) lorsque le commutateur à semi-conducteur (1) est commandé dans un fonctionnement linéaire.

5. Dispositif de commande (4) selon l'une quelconque des revendications 1 à 4, qui est conçu pour commander un commutateur IGBT (1).

6. Dispositif de commande (4) selon la revendication 5, dans lequel le dispositif régulateur de courant (18) est couplé à la borne de collecteur (11) du commutateur IGBT (1) et est alimenté en tension de fonctionnement à partir de la borne de collecteur (11).

7. Système d'entraînement (100) destiné à une machine électrique à n phases (3), dans lequel n ≥ 1, comportant :
un condensateur de circuit intermédiaire (2) qui est connecté à deux bornes de tension d'entrée (T+ ; T-) ;
un onduleur (10) ayant une pluralité de commutateurs à semi-conducteur (1a, ..., 1f), qui est couplé au condensateur de circuit intermédiaire (2), est alimenté en énergie électrique à partir du condensateur de circuit intermédiaire (2) et est conçu pour générer une tension d'alimentation à n phases pour la machine électrique (3) ;
une pluralité de dispositifs de commande (4a, ..., 4f) selon l'une quelconque des revendications 1 à 6, qui sont respectivement conçus pour générer un signal de commande de commutation (7a, ..., 7f) pour l'un des commutateurs à semi-conducteur (1a, ..., 1f) de l'onduleur (10) ; et
une régulation de commande (50) qui est couplée à la pluralité des dispositifs de commande (4a, ..., 4f) et qui est conçue pour générer des signaux de commutation (5a, ..., 5f) pour les commutateurs à semi-conducteur (1a, ..., 1f) de l'onduleur (10).

8. Système d'entraînement (100) selon la revendication 7, dans lequel les commutateurs à semi-conducteur (1a, ..., 1f) sont des commutateurs IGBT.

9. Procédé (30) de commande d'un onduleur (100), comportant les étapes consistant à :
amplifier (31) un signal de commutation (5a, ..., 5f) pour chacun des commutateurs à semi-conducteur (1a, ..., 1f) de l'onduleur (10) afin de générer une pluralité de premiers signaux de commande de commutation qui commandent chacun un commutateur à semi-conducteur (1a, ..., 1f) dans un fonctionnement de commutation ;
mesurer (32) l'intensité d'un courant passant à travers chacun des commutateurs à semi-conducteur (1a, ..., 1f) ;
générer (33) une pluralité de deuxièmes signaux de commande de commutation qui commande chacun un commutateur à semi-conducteur (1a, ..., 1f) dans un fonctionnement linéaire, en fonction de l'intensité mesurée du courant passant à travers les commutateurs à semi-conducteur (1a, ..., 1f) ; et
sélectionner (34) le premier signal de commande de commutation ou le deuxième signal de commande de commutation afin de commander une borne de commande de chacun des commutateurs à semi-conducteur (1a, ..., 1f) en fonction d'au moins un signal de sélection de fonctionnement (6a, ..., 6f) pour chacun des commutateurs à semi-conducteur (1a, ..., 1f).

10. Procédé (30) selon la revendication 9, dans lequel l'onduleur (10) comprend une pluralité de branches de pont ayant chacune deux commutateurs à semi-conducteur (1a, ..., 1f), dans lequel l'au moins un signal de sélection de fonctionnement indique un fonctionnement de décharge de secours de l'onduleur (10), et dans lequel, pour chaque commutateur à semi-conducteur (1a, 1b, 1c) de chaque branche de pont, le premier signal de commande de commutation est sélectionné et, pour chacun des autres commutateurs à semi-conducteur (1d, 1e, 1f) de chaque branche de pont, le deuxième signal de commande de commutation est sélectionné pour commander les bornes de commande respectives.
